# EUROPEAN PATENT SPECIFICATION

(11) **EP 4 402 489 B1**
(45) Date of publication and mention of the grant of the patent: **09.12.2026**
(21) Application number: 22790024.8
(22) Date of filing: 13.09.2022
(51) Int. Cl.: G01R 1/067, G01R 1/073, G01R 3/00, G01R 31/28

(54) **ASSEMBLY FOR TESTING DEVICE FOR PRINTED CIRCUIT BOARDS, METHOF FOR REPLACING COMPONENTS OF A TESTING DEVICE AND METHOD FOR TESTING A PRINTED CIRCUIT BOARD**
ANORDNUNG FÜR EINE PRÜFVORRICHTUNG FÜR LEITERPLATTEN, VERFAHREN ZUM ERSETZEN VON KOMPONENTEN EINER PRÜFVORRICHTUNG UND VERFAHREN ZUM PRÜFEN EINER LEITERPLATTE
ENSEMBLE POUR DISPOSITIF DE TEST POUR CARTES DE CIRCUIT IMPRIMÉ, PROCÉDÉ POUR REMPLACER DES COMPOSANTS D'UN DISPOSITIF DE TEST ET PROCÉDÉ POUR TESTER UNE CARTE DE CIRCUIT IMPRIMÉ

(30) Priority: 13.09.2021 BE 202105715
(43) Date of publication of application: 24.07.2024
(73) Proprietor: IPTE Factory Automation NV, 3600 Genk (BE)
(72) Inventor: GEURTS, Tom, 3540 SCHULEN (BE); HAENEN, Gilbert Victor François, 3742 BILZEN (BE); CAPELLE, Wim, 8310 BRUGGE (BE)
(74) Representative: Arnold & Siedsma
(86) International application number: PCT/IB2022/058602
(87) International publication number: WO 2023/037345

(56) References cited:
- CN-A- 111 735 995
- CN-U- 206 258 489
- DE-B3- 10 234 709
- DE-C1- 19 811 795
- KR-Y1- 200 382 084
- US-A1- 2014 030 918

## Description

The invention relates to an assembly for a testing device for printed circuit boards, a testing device provided with one or more of such assemblies and to a method for replacing one or more components of a testing device for testing printed circuit boards and a method for testing a printed circuit board.

DE19811795, DE10234709, US2014/030918, KR200382084, CN111735995, CN 206 258 489 describe various test devices for electrical components.

It is known that printed circuit boards are currently used in a multitude of devices, including domestic appliances, medical devices, smart phones and (electronic) wearables. Such printed circuit boards are designed specifically for a product and, prior to integration thereof, are tested using a device which can check the operation of the printed circuit boards during or after the production process of the printed circuit boards. This is necessary in order to guarantee that the, often large numbers of, printed circuit boards are working correctly.

Such devices work by means of placing test pins, referred to as pins for short, on contact points on the printed circuit boards arranged specifically for this purpose. Arranged for this purpose is a contact plate which is provided with a pattern of openings corresponding with a pattern of the contact points, in and through which pins can move. This ensures that the pins are aligned with the contact points. Because miniaturization of electronic construction components such as printed circuit boards is on the rise, electric lines and functions coupled thereto will lie closer together.

In order to solve this problem, a system was developed in PCT/IB2021/053234 wherein a construction wherein the pins extend straight can be deviated from. The proximal end of the contact pin can hereby be provided at a substantially random distance, location and orientation relative to the distal end of the contact pin.

A drawback of this solution is that the complexity of the testing device increases and maintenance thereof becomes more difficult and more expensive.

The present invention has for its object to solve or at least reduce the above stated problem.

For this purpose the invention provides an assembly for a testing device for printed circuit boards according to claim 1. The assembly comprises
- a sleeve assembly configured to at least partially surround a pin, wherein the sleeve assembly and the pin are movable relative to each other, wherein the sleeve assembly is provided with:
   ~ a control plate sleeve which is operatively connectable to a control plate;
   ~ a sleeve provided with:
      - a proximal outer end connected operatively to the control plate sleeve; and
      - a distal outer end connectable to a contact plate of a testing device for printed circuit boards;
- a pin assembly comprising:
   ~ a pin base which is releasably placeable in the control plate sleeve; and
   ~ the pin which is connected with a proximal outer end to the pin base.

An advantage of the assembly according to the invention is that the pin assembly and the sleeve assembly are connected releasably to each other, whereby the pin assembly can be replaced separately of the sleeve assembly. This results in a cost reduction and in a faster implementation of the maintenance cycle.

An additional advantage is that, owing to said releasable connection, this construction also results in less environmental impact of the testing device as a whole.

A further advantage of the assembly according to the invention is that the pin assembly can also be removed from the testing device as a whole and can be replaced with a new assembly. Such an advantage can be increased further if one or more parts of the assembly are also releasably connected.

Yet another advantage of the assembly according to the invention is that it is applicable as standardized component in a testing device. In other words, a testing device can be provided with a (custom-)manufactured control plate and/or contact plate which can be connected to the assembly according to the invention. It is for instance the case here that use can be made of standard dimensions for the sleeve, the control plate sleeve and/or a contact plate sleeve. This can be a standard dimension for the length, but can alternatively or additionally also be a diameter. This enables more efficient and simpler manufacture of testing devices.

Yet another advantage is that the control plate sleeve forms a guide for insertion of the pin into the sleeve. The pin can then be guided into the sleeve during insertion.

In an embodiment of the assembly according to the invention the pin can be an at least partially flexible pin.

By giving the pin an at least partially and preferably wholly flexible form it is not necessary to align the control plate and the contact plate of a testing device. The control of the pins is thereby placed at a distance and it becomes possible to place pins closer together on the contact plate side.

In the assembly according to the invention a first outer end of the control plate sleeve can be releasably operatively connected to the sleeve.

An advantage of a releasable connection is that it can be released easily in order to replace one or more of the components, without all the components having to be removed and/or replaced simultaneously.

In an embodiment of the assembly according to the invention a first outer end of the control plate sleeve which is connected operatively to the sleeve can be shaped as one of a male or a female end, and the proximal outer end of the sleeve can be shaped as the other of a male or a female end, such that the first outer end and the proximal outer end are couplable, preferably slidably couplable.

An advantage of applying a male and a female end is that a connection between the control plate sleeve and the proximal outer end of the sleeve is realized in simple manner. This connection can be a fixed connection, such as an adhesive or welded connection, or can take the form of a releasable, for instance slidable, connection.

An advantage of a slidably couplable connection is that the components of the sleeve assembly are individually replaceable in that they can be uncoupled from each other in simple manner.

In the above stated embodiment diverse variants can be realized. In a first variant the first outer end of the control plate sleeve can be shaped as a male end or male part of a connection for forming and the distal outer end of the sleeve can be shaped as a female end or female part of the connection for forming. In this variant the female end of the sleeve is slid over the male part of the control plate sleeve in order to form the connection.

In a second variant of this embodiment the distal outer end of the sleeve can be shaped as a male end or male part of a connection for forming and the first outer end of the control plate sleeve can be shaped as a female end or female part of the connection for forming. In this variant the female end of the control plate sleeve is slid over the male part of the sleeve in order to form the connection.

The male and female end can be shaped in different ways as part of the control plate sleeve and the proximal part of the sleeve. The male part can thus for instance be formed by realizing a thinner wall while the inner diameter stays substantially the same. This results in a smaller outer diameter which can then be arranged in the female part. The female part can for instance be formed by a widening of the inner diameter, whereby an inner space with a greater diameter is achieved, in which the male part is arrangable. This can be realized with an outer diameter which remains substantially the same (and so a thinner wall), but can also be realized with a wall thickness which remains substantially the same and a greater outer diameter of the wall. This then results in a 'thickening' or 'bulge'. Other embodiments which result in the realization of a female and a male part for coupling however also fall within the scope of this embodiment of the invention.

In an embodiment of the assembly according to the invention the assembly can further comprise a coupling piece, wherein the coupling piece is preferably provided with a female coupling piece end and a male coupling piece end lying opposite the female coupling piece end, wherein the first outer end of the control plate sleeve is couplable to one of the male or female coupling piece end and the proximal outer end of the sleeve is couplable to the other of the male or female coupling piece end.

The coupling piece can here be connected releasably or fixedly to the control plate sleeve and/or the proximal outer end of the sleeve.

An advantage of this embodiment is that, owing to the use of the above stated coupling piece, the diameter of the control plate sleeve and/or the proximal part of the sleeve does not determine the possibility of coupling. In other words: the coupling piece makes it possible to realize the coupling irrespective of the respective outer diameters of the control plate sleeve and the proximal part of the sleeve.

A further advantage of using a coupling piece according to the invention is that substantially the same outer diameter can be applied for the control plate sleeve and the proximal part of the sleeve because, with the application of a coupling piece with a female and male connection, these can be coupled.

Yet another advantage is that the coupling piece can also form a guide for insertion of the pin into the sleeve. The pin can then be guided into the sleeve during insertion.

the assembly according to the invention the sleeve assembly is further provided with a contact plate sleeve which is connected operatively to the distal outer end of the sleeve, wherein the contact plate sleeve is connectable to the contact plate.

An advantage of this is that the assembly is more easily connectable to the contact plate.

In an embodiment of the assembly according to the invention one or more of the sleeve, the control plate sleeve and/or the contact plate sleeve can be a flexible and/or bendable sleeve.

An advantage of embodying one or more of the above stated sleeves as bendable or flexible sleeve is that the contact plate and the control plate need not be placed on one line. Because the sleeve or sleeves can also be placed at an angle or in a bend, more freedom of design of the device is created.

In an embodiment of the assembly according to the invention the contact plate sleeve can have a first outer end which is connected releasably to the distal outer end of the sleeve.

An advantage of a releasable connection is that it can be released easily in order to replace one or more of the components, without all the components having to be removed and/or replaced simultaneously. It is thus possible to replace for instance only the contact plate sleeve or only the sleeve.

Another advantage is that the sleeve and the contact plate sleeve co-act to form a guide for insertion of the pin into the sleeve.

In an embodiment of the assembly according to the invention the contact plate sleeve can have a first outer end which is shaped as one of a male or a female end, and the distal outer end of the sleeve can be shaped as the other of a male or a female end, such that the first outer end and the distal outer end are couplable, preferably slidably couplable.

An advantage of applying a male and a female end is that a connection between the contact plate sleeve and the distal outer end of the sleeve is realized in simple manner. This connection can be a fixed connection, such as an adhesive or welded connection, or can take the form of a releasable, for instance slidable, connection.

An advantage of a slidably couplable connection is that the components of the sleeve assembly are individually replaceable in that they can be uncoupled from each other in simple manner.

A further advantage is that connecting the contact plate sleeve to the contact plate can be performed before realizing a connection between the sleeve and the first outer end of the contact plate sleeve. This makes connecting of the contact plate sleeve, for instance by inserting it into a contact plate opening, easier to perform.

In this embodiment diverse variants for shaping said outer ends as male or female end can likewise be realized. Firstly, there is a choice of whether the first outer end of the contact plate sleeve or the distal outer end of the sleeve is shaped as male part. The other part will then of course be shaped as the other of the male end or the female end.

Diverse variants are additionally possible in respect of the shape of the male or female end, as long as they are compatible for forming a connection. The male part can thus for instance be formed by realizing a thinner wall while the inner diameter stays substantially the same. This results in a smaller outer diameter which can then be arranged in the female part. The female part can for instance be formed by a widening of the inner diameter, whereby an inner space with a greater diameter is achieved, in which the male part is arrangable. This can be realized with an outer diameter which remains substantially the same (and so a thinner wall), but can also be realized with a wall thickness which remains substantially the same and a greater outer diameter of the wall. This then results in a 'thickening' or 'bulge'. A combination of the above stated options is also possible. Other embodiments or variants wherein said outer ends are shaped as respectively a female end or a male end however also fall within the scope of this embodiment of the invention.

In an embodiment of the assembly according to the invention the assembly can further comprise a coupling piece, wherein the coupling piece is preferably provided with a female coupling piece end and a male coupling piece end, wherein the first outer end of the contact plate sleeve is couplable to one of the male or female coupling piece end and the distal outer end of the sleeve is couplable to the other of the male or female coupling piece end.

An advantage of this embodiment is that, owing to the use of the above stated coupling piece, the diameter of the contact plate sleeve and/or the distal part of the sleeve does not determine the possibility of coupling. In other words: the coupling piece makes it possible to realize the coupling irrespective of the respective outer diameters of the contact plate sleeve and the distal part of the sleeve.

A further advantage of using a coupling piece according to the invention is that substantially the same outer diameter can be applied for the contact plate sleeve and the distal part of the sleeve because, with the application of a coupling piece with a female and a male connection, these can be coupled, where this would not otherwise have been possible.

Yet another advantage is that the coupling piece can also form a guide for insertion of the pin into the contact plate sleeve. The pin can then be guided into the sleeve during insertion.

In an embodiment of the assembly according to the invention the contact plate sleeve can be releasably, preferably slidably, connectable to the contact plate.

An advantage of making the contact plate sleeve releasably connectable is that it can be connected to and released from the contact plate in simple manner, this further simplifying placing of the assembly.

A further advantage is that, when the contact plate sleeve is also connected releasably to the distal outer end of the sleeve, the contact plate sleeve can be replaced as separate component in the event that it is damaged or has reached the end of its lifespan. This prevents the other components of the assembly, such as the sleeve, also having to be replaced at the same time.

In an embodiment of the assembly according to the invention the control plate sleeve can be releasably, preferably slidably, connectable to the control plate.

An advantage of making the control plate sleeve releasably connectable is that it can be connected to and released from the control plate in simple manner, this further simplifying placing of the assembly.

A further advantage is that, when the control plate sleeve is also connected releasably to the proximal outer end of the sleeve, the control plate sleeve can be replaced as separate component in the event that it is damaged or has reached the end of its lifespan. This prevents the other components of the assembly, such as the sleeve, also having to be replaced at the same time.

In an embodiment of the assembly according to the invention the proximal pin end can be connected movably to the pin base.

An advantage of arranging the proximal pin end movably on the pin base is that it becomes possible to move the pin relative to the pin base, such as during sliding to and from the printed circuit board. This for instance means that the pin is actuable by coupling or arranging an actuator to or in the pin base.

This achieves that the pin is movable to the printed circuit board for testing rather than the printed circuit board being moved to the pin. The result hereof is that the transport of the printed circuit boards for testing can be performed in simpler and more efficient manner.

In an embodiment of the assembly according to the invention the pin assembly can further comprise retracting means which connect the pin base and the pin to each other, wherein the pin base and the pin are movable relative to each other and wherein the retracting means are configured to push the pin to a retracted position relative to the contact plate, wherein the retracting means preferably comprise a spring.

An advantage of this embodiment is that unintended protruding of the pin from the contact plate and resultant damage to the pin is substantially prevented. In the case that said spring is applied, it can be arranged biased in order to keep the pin in the retracted position when no other actuating operation is being exerted on the pin.

It is preferably the case that in the retracted position the pin does not protrude outside the contact plate sleeve and/or contact plate, so that the contact plate sleeve and/or contact plate provides protection and/or support to the pin.

The invention further relates to a testing device for printed circuit boards comprising at least one assembly according to any one of the foregoing claims.

The testing device for printed circuit boards according to the invention has the same effects and advantages as the assembly according to the invention. The same embodiments as described for the assembly according to the invention can also be applied in the testing device.

The testing device for printed circuit boards is otherwise also referred to as printed circuit board testing device, and these terms are therefore synonymous in the context of the invention.

In an embodiment of the testing device according to the invention the testing device can further comprise at least one contact plate, at least one control plate and drive means, wherein the drive means are connected operatively to or form part of the at least one control plate and are configured to move the pins through the contact plate. The distal outer end of the sleeve of each of the at least one assembly can be operatively connected to the contact plate and each control plate sleeve of each of the at least one assembly can be operatively connected to the control plate.

An advantage of the testing device according to this embodiment of the invention is that the assembly, and/or one or more different components thereof, are individually replaceable. It becomes possible hereby to replace assemblies, or even individual components thereof, selectively without other assemblies, the contact plate and/or the control plate having to be replaced. This results in a reduction of the downtime of the device. This also results in a reduction of the maintenance costs of the device and less environmental impact.

A further advantage of the testing device according to the invention is that the pin assembly is replaceable separately of the sleeve assembly, making it possible to replace the pin, as part of the pin assembly, without replacing the sleeve assembly and/or uncoupling it from the testing device.

Yet another advantage of the testing device according to the invention is that it can be adapted to a different testing situation in simple manner in that the assemblies can be uncoupled from the other components of the device. The contact plate and/or the control plate can thus be adapted to a different testing situation using the existing assemblies present in the testing device. These assemblies can be uncoupled and be connected to a different contact plate and/or control plate in simple manner.

In an embodiment of the testing device according to the invention each control plate sleeve can be arranged, preferably arranged slidably, in a control plate opening of the control plate.

Arranging the control plate sleeve, preferably slidably, in an opening of the control plate has the advantage that the control plate sleeve can be easily arranged and/or removed. This shortens the maintenance time, which also decreases the maintenance costs.

In an embodiment of the testing device according to the invention each assembly can be provided with a contact plate sleeve and the contact plate can be provided with contact plate openings, wherein each contact plate sleeve extends at least partially in the contact plate opening.

Arranging the contact plate sleeves in contact openings in the contact plate intended for this purpose has the advantage that a good connection is formed and that the positioning of the assemblies relative to each other corresponds to the positioning of the contact points on the printed circuit board for testing.

It is preferably the case that the contact plate sleeve extends over a whole length of the opening in the contact plate, and a second outer end of the contact plate sleeve (lying opposite the first outer end connected to the sleeve) more preferably even protrudes outside the contact plate over a determined length so that a good guiding and support of the pin to a position nearby the printed circuit board for testing is realized. An advantage hereof his that this results in a more stable positioning of the pin on the printed circuit board.

In an embodiment of the testing device according to the invention the at least one contact plate can consist of two or more layers, or a plurality of contact plates can be mutually connected in order to realize a multilayer contact plate.

In an embodiment of the testing device according to the invention the pins can be electrically connected to the testing means.

The invention further relates to a method for replacing one or more components of a testing device for testing printed circuit boards according to claim 14. The method comprises:
- providing a testing device according to the invention;
- removing the pin assembly from one or more assemblies;
- replacing one or more components of the assembly; and
- placing the pin assembly in the one or more assemblies.

The method for replacing one or more components of a testing device for testing printed circuit boards according to the invention has the same effects and advantages as the assembly and the testing device according to the invention. The same embodiments as described for the assembly and/or the testing device according to the invention can also be applied in the method.

An advantage of the method according to the invention is that one or more assemblies are mutually releasable and replaceable independently of each other, this reducing the maintenance time and thereby maintenance costs.

A further advantage of the method according to the invention is that, owing to the independence of the assemblies relative to each other, only a part of the assemblies requiring replacement need be replaced.

In an embodiment of the method according to the invention the step of replacing one or more components of the assembly can comprise one or more of:
- replacing the pin assembly; and/or
- replacing the sleeve of the sleeve assembly by:
   - uncoupling the distal and proximal outer end of the sleeve from respectively the contact plate and the control plate sleeve;
   - removing the sleeve;
   - placing the new sleeve and connecting the distal and proximal outer end of the sleeve to respectively the contact plate and the control plate sleeve; and/or
- replacing the contact plate sleeve of the sleeve assembly by:
   - uncoupling the distal outer end of the sleeve from the contact plate sleeve;
   - removing the contact plate sleeve;
   - placing a new contact plate sleeve; and
   - connecting the distal outer end of the sleeve to the contact plate sleeve, and/or
- replacing the control plate sleeve of the sleeve assembly by:
   - uncoupling the proximal outer end of the sleeve from the control plate sleeve;
   - removing the control plate sleeve;
   - placing a new control plate sleeve; and
   - connecting the proximal outer end of the sleeve to the control plate sleeve.

An advantage of these steps is that each of the components can be replaced individually, without the other components having to be replaced for this purpose. In many cases only the pin assembly and the component for replacing need be removed, so that few operations are needed and time and money are saved.

A further advantage is that the environmental impact of this method is relatively low because only the essential components for replacing are replaced.

The invention further relates to a method for testing a printed circuit according to claim 15. The method comprises:
- providing a testing device according to the invention;
- providing at least one object for testing;
- testing the object for testing;
- optionally repeating the steps of providing an object for testing and testing the object for testing.

The method for testing a printed circuit board according to the invention has the same effects and advantages as the assembly, the testing device and the method for replacing one or more components of a testing device according to the invention. The same embodiments as described for the assembly and/or the testing device and/or the method for replacing one or more components of a testing device according to the invention can also be applied in the method.

In an embodiment of the method for testing a printed circuit board according to the invention the step of testing the object for testing can comprise of:
- positioning an object for testing, such as a printed circuit board, in a test position relative to the testing device;
- pushing the pins to a test position, in which the pins make electrical contact with the electrical connections, by means of drive means, wherein the pins move at least partially through the sleeve assembly and the contact plate;
- testing the object for testing; and
- retracting the pins from the test position to a rest position, in which a distal outer end of the pins lies clear of the object for testing;
- optionally releasing the fixation of the object for testing relative to the contact plate; and
- removing the tested object.

An advantage of the above stated steps is that the object for testing, such as a printed circuit board, is first positioned relative to the testing device, and particularly the contact plate thereof. It is the case here that the positioning relative to can also be the positioning in the testing device and relative to the contact plate. The starting point for the positioning is that the contact points on the object for testing, also referred to as testing object, are aligned with openings in the contact plate and the pins moving therethrough so that electrical contact can be made.

For this purpose fixing is optionally advantageously possible, so that this relative position is preserved during testing and the method becomes (even) less prone to error.

Further advantages, features and details of the invention are elucidated on the basis of preferred embodiments thereof, wherein reference is made to the accompanying drawings, in which:
Figure 1 shows a first example of an assembly according to the invention;
Figure 2A shows the sleeve assembly of the example of figure 1;
Figure 2B shows the pin assembly of the example of figure 1;
Figures 3A-3E show a number of examples of options for operatively connecting the sleeve of the assembly according to the invention to a contact plate of a testing device for printed circuit boards;
Figures 4A-4E show a number of examples of options for operatively connecting the sleeve of the assembly according to the invention to a control plate of a testing device for printed circuit boards;
Figure 5 shows two examples of a (partially) bent configuration of the assembly close to the contact plate;
Figure 6 shows an example of a method according to the invention for replacing one or more components of a testing device for testing printed circuit boards; and
Figure 7 shows an example of the method according to the invention for testing a printed circuit board.

For interpretation of this patent text, the following definitions will apply. A printed circuit board or printed circuit is a collective name for different types of electronic building block. The most common electronic building block is board-shaped, although hybrid, wireframe, modules, 3D electronics and other electronic building blocks, which are not necessarily board-shaped, will also be deemed printed circuit boards. These can for instance be round and/or uneven/irregular shapes. A contact plate is a component in the device which has a shape compatibility with the printed circuit board. Just as the printed circuit board is not necessarily board-shaped, the contact plate will likewise not necessarily be board-shaped, but can also be adapted to the shape of the printed circuit board and/or to the shape of the sleeve, for instance be block-shaped. A sleeve is defined as a hollow cylindrical or tubular element which functions as casing, for instance for a segment of a cable or wire. A control plate is a component in the device which need not necessarily be board-shaped but can also have other shapes, for example can be adapted to the specific arrangement of pin assemblies. The control plate is thus understood to mean a control element which can be board-shaped, but for instance also block-shaped, circular, cylindrical or another suitable shape. In the text, a testing device for printed circuit boards is also understood to mean a printed circuit board testing device, wherein the printed circuit board or printed circuit can comprise all the above stated different types of electronic building block.

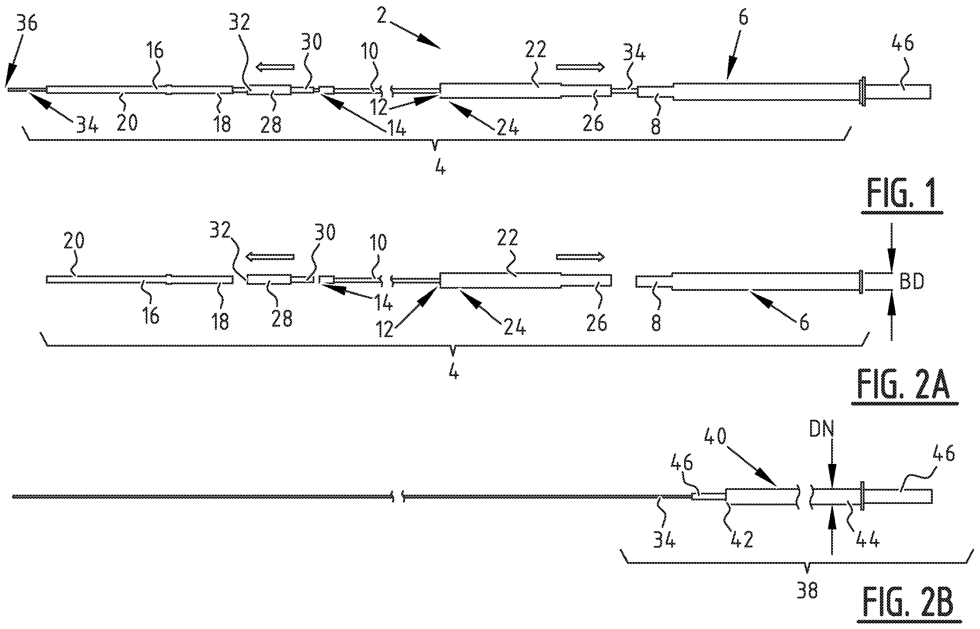

In a first example (see figures 1, 2A) assembly 2 comprises a sleeve assembly 4 which is provided with control plate sleeve 6 with first outer end 8, with sleeve 10 with proximal outer end 12 and distal outer end 14, and with contact plate sleeve 16 with first outer end 18 and second outer end 20. It is the case here that figure 1 shows assembly 2 as a whole, so including sleeve assembly 4 and pin assembly 38. Figure 2A shows sleeve assembly 4 (without pin assembly 38, which pin assembly 38 is shown in figure 2B).

In this example (see figures 1, 2A) it is the case that the connection between proximal outer end 12 of sleeve 10 and first outer end 8 of control plate sleeve 6 is formed using coupling piece 22, which is provided with female coupling piece end 24 and male coupling piece end 26. In this example first outer end 8 is embodied as a female end 8 so that male coupling piece end 26 is placeable, in this case slidable, into female end 8 of control plate sleeve 6. Proximal outer end 12 of sleeve 10 is in this example embodied as male end 12 which forms a connection by means of sliding into female coupling piece end 24. The connections preferably take the form of releasable connections. The sliding force is preferably sufficient here to prevent the connections from coming loose due to the movement of pin 34 in sleeve 10 and control plate sleeve 6.

In this example distal outer end 14 of sleeve 10 is embodied as female end 14 which is connected slidably to first, male coupling piece end 30 of coupling piece 28. The connection is preferably a releasable connection, wherein the sliding force is sufficient here to prevent the connection from coming loose due to the movement of pin 34 in sleeve 10 and coupling piece 28. In this example the second, female coupling piece end 32 of coupling piece 28 is connected to the first outer end 18, formed as male end, of contact plate sleeve 16.

In this example pin 34 (see figure 1) extends through the hole sleeve assembly 4 and at second outer end 20 of contact plate sleeve 16 extends partially outside contact plate sleeve 16. Printed contact end 36 of pin 34 can hereby be brought into contact with a printed circuit board for testing (not shown in this example). It must be noted here that figure 1 is a representation wherein pin 34 is in a partially extended state so that pin end 36 of pin 34 protrudes outside the contact plate and second outer end 20 of contact plate sleeve 16.

In this example pin assembly 38 (see figures 1, 2B) is provided with pin base 40, pin 34 and plunger 46. Pin assembly 38 is placeable in (and in figure 1 placed in) control plate sleeve 6. Figure 1 shows here assembly 2 including sleeve assembly 4 and pin assembly 38. Figure 2B shows pin assembly 38 in uncoupled state, in which pin assembly 38 is uncoupled from sleeve assembly 4.

In this example (see figure 2B) pin 34 is received in pin base 40 and extends at least partially therein. At first pin base end 42 pin 34 protrudes outside pin base 40 for placing and movable passage through sleeve assembly 4. Arranged on second pin base end 44 in this example (see figures 1, 2B) is plunger 46, which is operatively connected to a drive means (not shown) for moving pin 34 in assembly 2. Plunger 46 is here arranged movably relative to pin base 40 and connected, preferably fixedly, to pin 34. It is noted that a releasable and/or pluggable connection of pin 34 and plunger 46 is also possible. A reciprocal movement of plunger 46 in pin base 40 thereby results in pin 34 respectively extending and/or retracting through sleeve assembly 4 and pin base 40. In other words, pin 34 is movable in sleeve assembly 4 and pin base 40 by means of plunger 46 and drive means 48.

For this purpose outer diameter DN of pin base 40 and inner diameter BD of control plate sleeve 6 are embodied in this example such that pin base 40 can be arranged slidably in control plate sleeve 6. The fit is preferably such that it cannot be uncoupled below a predetermined force. Figure 1 shows pin assembly 38 with pin base 40 arranged slidably in control plate sleeve 6 of sleeve assembly 4. The connection between proximal outer end 12 of sleeve 10 and first outer end 8 of control plate sleeve 6 and the connection between first outer end 18 of contact plate sleeve 16 to distal outer end 14 of sleeve 10 can be brought about in a number of ways, for instance with or without coupling piece or pieces 22, 28. The positioning of the assembly relative to the contact plate and/or to the control plate can further be realized in different ways.

In respect of the connection of assembly 2, 102 to contact plate 150 it is the case that contact plate sleeve 116 can for instance be operatively connected in various ways.

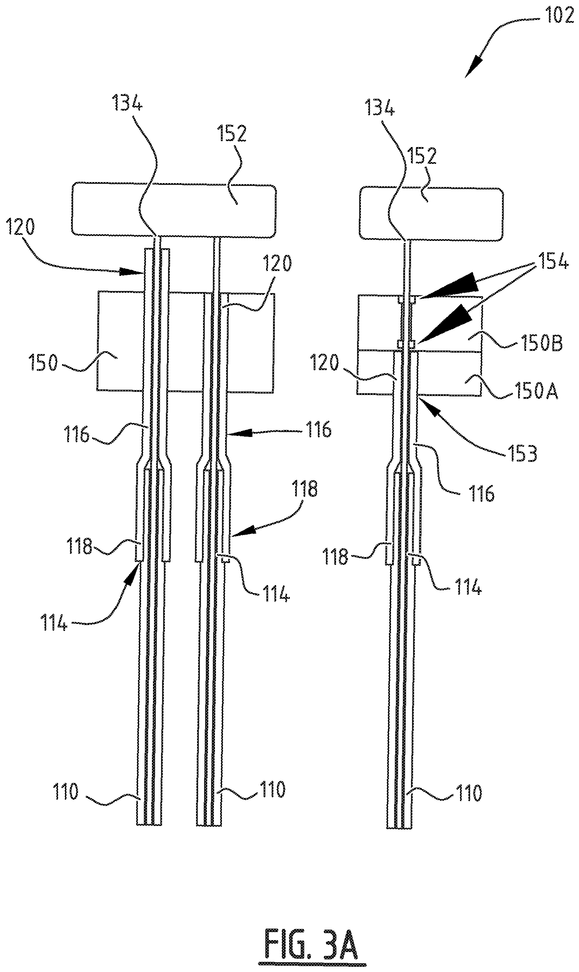

In a first example contact plate sleeve 116 can thus for instance reach through contact plate 150 (see figure 3A-3E: embodiment on the left), whereby contact plate sleeve 116 also supports pin 134 outside contact plate 150 and close to printed circuit board 152.

In a second example contact plate sleeve 116 can also be arranged in contact plate 150 such that second outer end 120 lies flush with a side of contact plate 150 (figures 3A-3E: middle embodiment). In a third example of a possible embodiment (see figures 3A-3E: embodiment on the right) contact plate sleeve 116 can be slid partially into contact plate 150, such that second outer end 120 is situated in contact plate 150. Contact plate 150 can here be constructed from two or more layers, wherein contact plate sleeve 116 is preferably arranged in a first layer 150a. A second (or further) contact plate layer 150b has an opening with a smaller diameter than the opening 153 in contact plate 150a, such that pin 134 is guided through the opening. A further guide 154 of pin 134 can optionally be provided in contact plate 150b for the purpose of guiding pin 134.

In a first example (see figure 3A) distal outer end 114 of sleeve 110 is shaped as male end 114. In this example sleeve 110 has a constant inner and outer diameter toward distal outer end 114. In this example first outer end 118 of contact plate sleeve 116 is shaped as female end 118 having an inner diameter which is greater than an inner diameter of a remaining part of contact plate sleeve 116. Distal outer end 114 of sleeve 110 is placed in female end 118 of contact plate sleeve 116. Second outer end 120 of contact plate sleeve 116 has an outer diameter such that it is arrangeable in an opening of contact plate 150. In this example the outer diameter of second outer end 120 is roughly equal to the outer diameter of distal outer end 114 of sleeve 110.

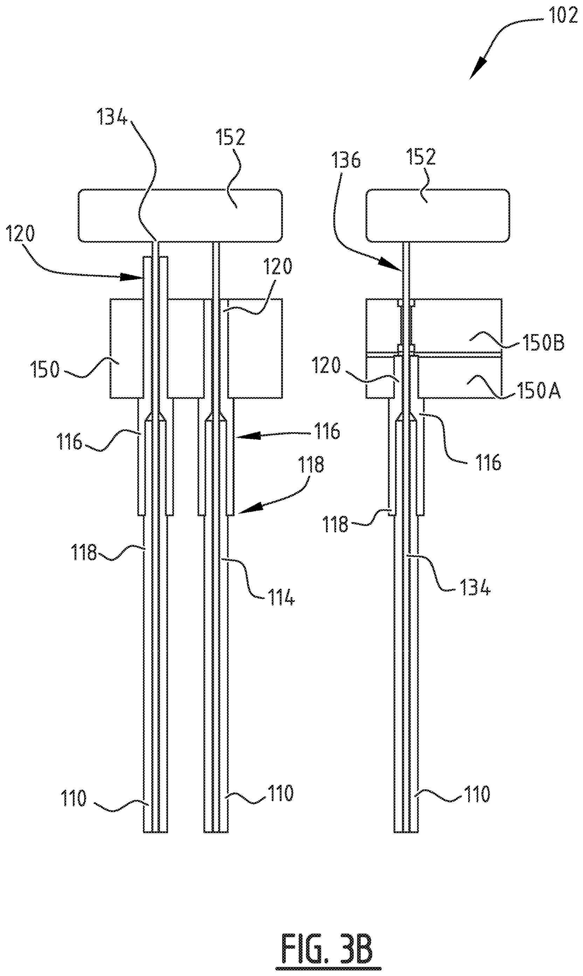

In a second example (see figure 3B) it is the case that sleeve 110 has a constant inner and outer diameter toward distal outer end 114. In this example first outer end 118 of contact plate sleeve 116 is shaped as female end 118 having an inner diameter which is greater than an inner diameter of a remaining part of contact plate sleeve 116. Distal outer end 114 of sleeve 110 is placed in female end 118 of contact plate sleeve 116. Second outer end 120 of contact plate sleeve 116 has an outer diameter such that it is arrangeable in an opening of contact plate 150. In this example the outer diameter of second outer end 120 is roughly equal to the outer diameter of distal outer end 114 of sleeve 110. The transition between the (greater) outer diameter of first outer end 118 to the (smaller) outer diameter of second outer end 120 is further shaped as a flange which lies against a side wall of contact plate 150. In this example outer end 136 of pin 134 lies against a contact for testing on an object, such as a printed circuit board.

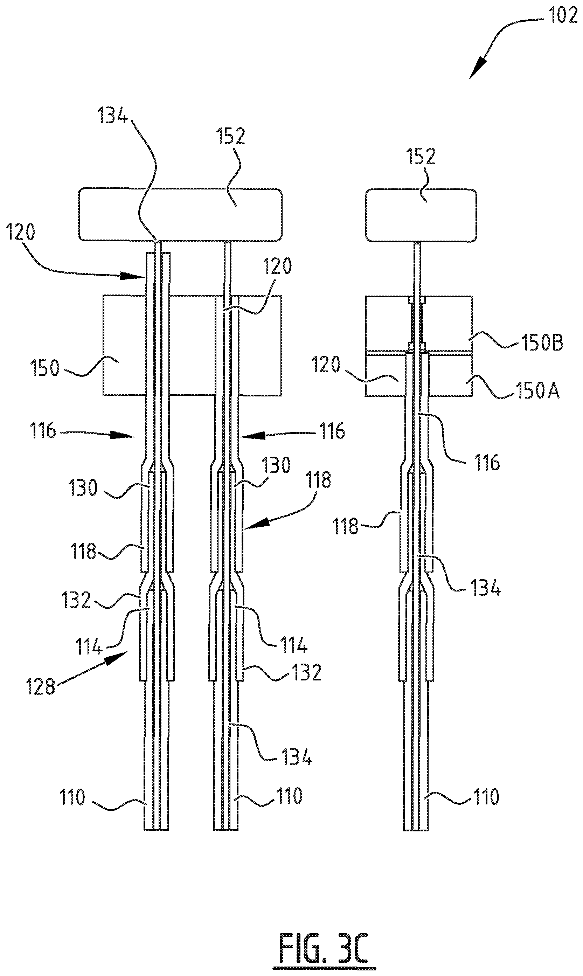

In a third example (see figure 3C) distal outer end 114, which is shaped as male outer end 114 and has a constant inner and outer diameter, is connected to female end 132 of coupling piece 128. The other outer end 130 of coupling piece 128 is shaped as male end 130 which is coupled to first outer end 118 of contact plate sleeve 116, wherein first outer end 118 is shaped as female part. Second outer end 120 of contact plate sleeve 116 has an outer diameter such that it is arrangeable in an opening of contact plate 150.

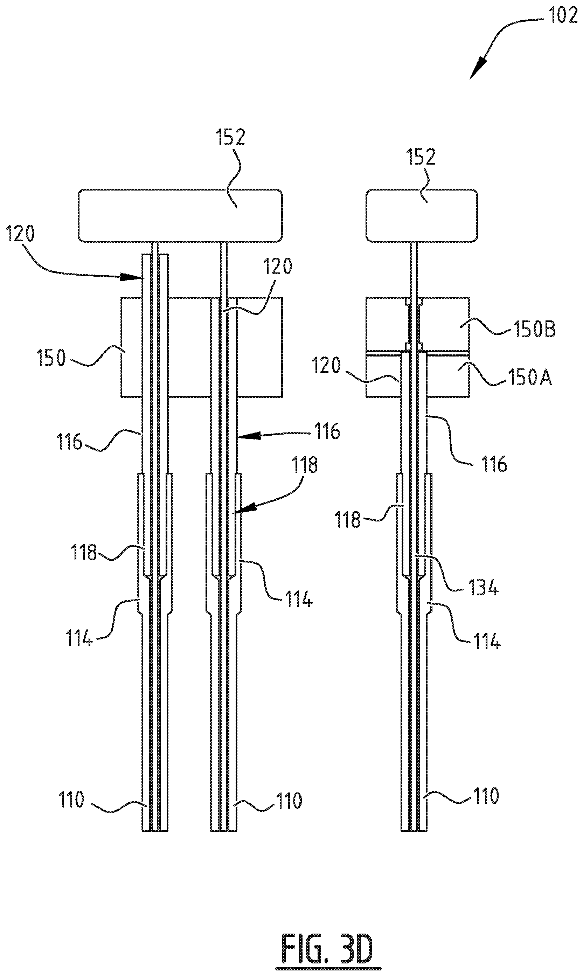

In a fourth example (see figure 3D) first outer end 114 of sleeve 110 is shaped as female end 114. First outer end 118 of contact plate sleeve 116 is shaped as male end 118 which is received in female end 114 in order to form the connection. Female end 114 has here a greater outer diameter than part of sleeve 110 connecting to this female end. Second outer end 120 of contact plate sleeve 116 has an outer diameter such that it is arrangeable in an opening of contact plate 150.

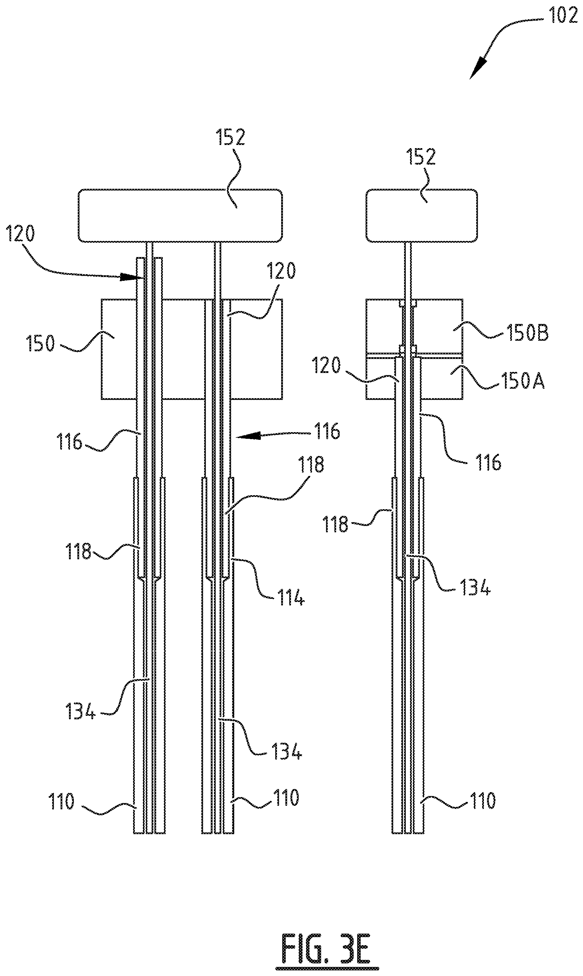

In a fifth example (see figure 3E) first outer end 114 of sleeve 110 is shaped as female end 114. First outer end 118 of contact plate sleeve 116 is shaped as male end 118 which is received in female end 114 in order to form the connection. In this example it is the case that the outer diameter of female end 114 is equal to the outer diameter of a part of sleeve 110 connecting to this female end, so that sleeve 110 has the same outer diameter all the way to outer end 114. Sleeve 110 hereby has a greater wall thickness than the other stated examples. Second outer end 120 of contact plate sleeve 116 has an outer diameter such that it is arrangeable in an opening of contact plate 150.

The connections between contact plate sleeve 116 and contact plate 150, contact plate sleeve 116 and first outer end 114 of sleeve 110 or, alternatively, the connections between contact plate sleeve 116, coupling piece 128 and first outer end 114 can take different forms.

It is possible here to envisage a press fit, an adhesive connection, a sliding connection, for instance on the basis of friction, or a suitable chemical compound. A releasable connecting method, such as a sliding connection, is however preferably opted for because replacing of the assembly 2, 102 and/or components thereof is easy to carry out.

In respect of the connection of assembly 2, 102 202 to control plate 254 it is the case that control plate sleeve 206 can for instance be connected to sleeve 210 in various ways.

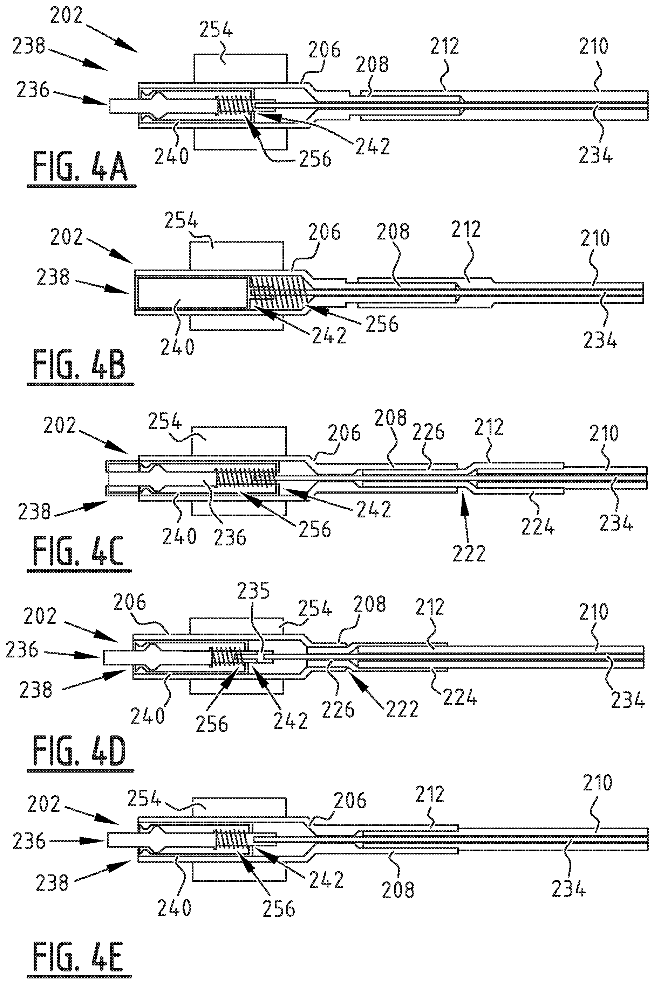

In a first example (see figure 4A) control plate sleeve 206 (shown schematically) extends at least partially in control plate 254. First outer end 208 of control plate sleeve 206 protrudes outside control plate 254 and is shaped as male end 208. In this example proximal outer end 212 of sleeve 210 is shaped as female end 212 which is placed over male end 208. In this example the outer diameter of sleeve 210 is equal to the outer diameter of female end 212 and sleeve 210 thereby has a relatively great wall thickness. Pin assembly 238 is received at least partially in control plate sleeve 206, wherein pin base 240 extends at least partially in control plate sleeve 206. Plunger 236 extends inside pin base 240, which plunger is connected to pin 234 in order to enable control of pin 234. Pin 234 extends through control plate sleeve 206 and sleeve 210 toward the distal outer end (not shown) of pin 234.

Plunger 236 is arranged movably in pin base 240 and is connected by means of spring 256 to first pin base end 242. This spring connection ensures that pin 234 is always brought into a starting position or retracted position when no external force is being exerted on plunger 236. This protects pin 234 against damage.

In a second example (see figure 4B) control plate sleeve 206 (shown schematically) extends at least partially in control plate 254. First outer end 208 of control plate sleeve 206 protrudes outside control plate 254 and is shaped as male end 208. In this example proximal outer end 212 of sleeve 210 is shaped as female end 212 which is placed over male end 208. In this example the outer diameter of sleeve 210 is smaller than the outer diameter of female end 212. Female end 212 thereby has a tulip shape and/or forms a thickened portion relative to sleeve 210. Pin assembly 238 is received at least partially in control plate sleeve 206, wherein pin base 240 extends at least partially in control plate sleeve 206. Pin 234 is connected operatively to first pin base end 242 and extends through control plate sleeve 206 and sleeve 210 toward the distal outer end (not shown) of pin 234.

In this example pin 234 is movable in sleeve assembly 204 by means of pin base 240. Pin base 240 is provided on first outer end 242 with a connecting projection in which pin 234 is arranged. First outer end 242 is further connected by means of a spring to control plate sleeve 206 so that pin base 240 is movable relative to control plate sleeve 206. This achieves that pin 234 is always brought into a starting position or retracted position when no external force is being exerted on pin base 240. This protects pin 234 against damage.

In a third example (see figure 4C) control plate sleeve 206 (shown schematically) extends at least partially in control plate 254. First outer end 208 of control plate sleeve 206 protrudes outside control plate 254 and is shaped as female end 208. In this example proximal outer end 212 of sleeve 210 is shaped as male end 212. In this example sleeve 210 and control plate sleeve 206 are connected using coupling piece 222. Coupling piece 222 is provided with female end 224 in which proximal outer end 212 of sleeve 210 is received. An opposite outer end 226 of coupling piece 222 is shaped as male end 226 which is placed in female end 208 of control plate sleeve 206.

In this example the outer diameter of female end 224 of coupling piece 222 is roughly equal to the outer diameter of female end 208 of control plate sleeve 206.

Pin assembly 238 is received at least partially in control plate sleeve 206, wherein pin base 240 extends at least partially in control plate sleeve 206 and, on the rear side, at least partially outside control plate sleeve 206. Plunger 236 extends inside pin base 240, which plunger is connected to pin 234 in order to enable control of pin 234. Pin 234 extends through control plate sleeve 206, coupling piece 222 and sleeve 210 toward the distal outer end (not shown) of pin 234.

Plunger 236 is arranged movably in pin base 240 and is connected by means of spring 256 to first pin base end 242. This spring connection ensures that pin 234 is always brought into a starting position or retracted position when no external force is being exerted on plunger 236. This protects pin 234 against damage.

In the above stated examples it is the case that pin assembly 238 and/or pin 234 are arranged releasably in control plate sleeve 206 and, in the case of pin 234, in sleeve 210, so that they can be easily replaced.

In a fourth example (see figure 4D) control plate sleeve 206 (shown schematically) extends at least partially in control plate 254. First outer end 208 of control plate sleeve 206 protrudes outside control plate 254 and is shaped as female end 208. In this example proximal outer end 212 of sleeve 210 is shaped as male end 212. In this example sleeve 210 and control plate sleeve 206 are connected using coupling piece 222. Coupling piece 222 is provided with female end 224 in which proximal outer end 212 of sleeve 210 is received. An opposite outer end 226 of coupling piece 222 is shaped as male end 226 which is placed in female end 208 of control plate sleeve 206. In this specific example it is the case that male end 226 protrudes into the female end 208 of control plate sleeve 206.

In this example the outer diameter of female end 224 of coupling piece 222 is roughly equal to the outer diameter of female end 208 of control plate sleeve 206.

Pin assembly 238 is received at least partially in control plate sleeve 206, wherein pin base 240 extends at least partially in control plate sleeve 206. Plunger 236 extends inside pin base 240, which plunger is in this example connected releasably to pin 234 in order to enable control of pin 234. In this example the releasable connection is realized using connecting element 235 or coupling piece 235. Coupling piece 235 is positioned with a first outer end in plunger 236 and is provided at a second, opposite outer end with a receiving recess for receiving the pin end of pin 234. Pin 234 extends through control plate sleeve 206 and sleeve 210 toward the distal outer end (not shown) of pin 234.

Plunger 236 is arranged movably in pin base 240 and is connected by means of spring 256 to first pin base end 242. This spring connection ensures that pin 234 is always brought into a starting position or retracted position when no external force is being exerted on plunger 236. This protects pin 234 against damage.

In a fifth example (see figure 4E) control plate sleeve 206 (shown schematically) extends at least partially in control plate 254. First outer end 208 of control plate sleeve 206 protrudes outside control plate 254 and is shaped as female end 208. In this example proximal outer end 212 of sleeve 210 is shaped as male end 212, which is placed in female end 208 of control plate sleeve 206.

Pin assembly 238 is received at least partially in control plate sleeve 206, wherein pin base 240 extends at least partially in control plate sleeve 206. Plunger 236 extends inside pin base 240, which plunger is connected fixedly to pin 234 in order to enable control of pin 234. Pin 234 extends through control plate sleeve 206, coupling piece 222 and sleeve 210 toward the distal outer end (not shown) of pin 234.

Plunger 236 is arranged movably in pin base 240 and is connected by means of spring 256 to first pin base end 242. This spring connection ensures that pin 234 is always brought into a starting position or retracted position when no external force is being exerted on plunger 236. This protects pin 234 against damage.

In the above stated examples (see figures 4A-4E) it is the case that pin assembly 238 and/or pin 234 are arranged releasably in control plate sleeve 206 and, in the case of pin 234, in sleeve 210, so that they can be easily replaced.

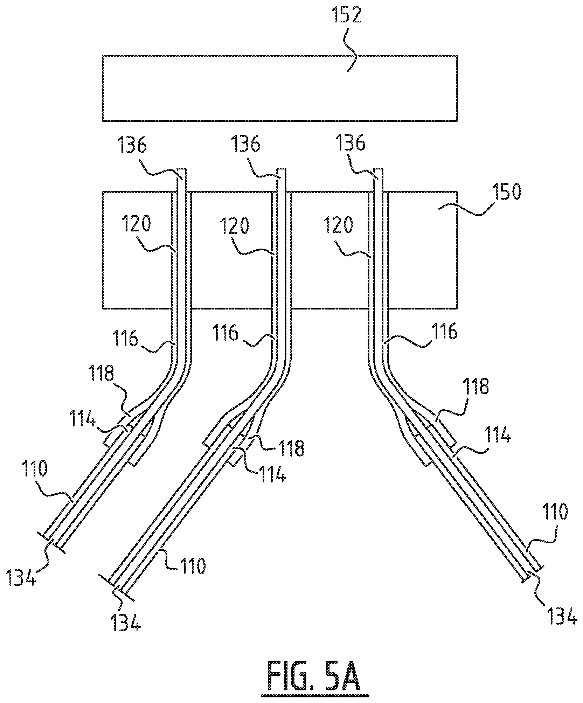

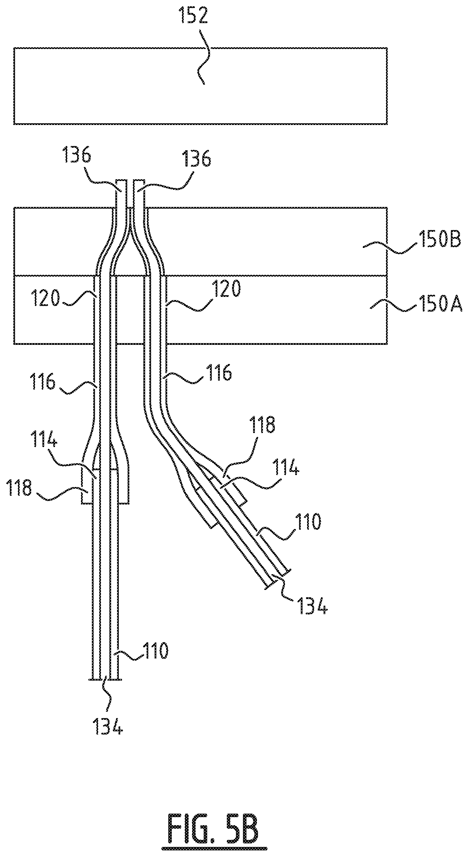

In a further example (see figures 5A, 5B) a partially bent configuration of the assembly is shown close to the contact plate. Figure 5A shows three assemblies which are arranged in contact plate 150. In this example each of the contact plate sleeves 116 protrudes up to an edge of contact plate 150, wherein in the shown, partially extended state pin end 136 of pin 134 protrudes outside contact plate 150 toward test object 152, in this case printed circuit board 152.

On the other side of contact plate 150 contact plate sleeve 116 is arranged partially bent and connected at first outer end 118 to distal outer end 114 of sleeve 110. In principle the bend of contact plate sleeve 116 could also be arranged at the position of the connection to sleeve 110.

Figure 5 shows an alternative example, wherein contact plate 150 consists of two layers 150A, 150B. Contact plate sleeves 116 of the assemblies are arranged at a determined distance from each other in openings of contact plate sleeve layer 150A. In contact plate sleeve layer 150B the openings converge until the two openings are placed closer together at the surface of contact plate sleeve layer 150B than in contact plate sleeve layer 150A. The two second contact plate ends 120 end at the transition between contact plate sleeve layer 150A and contact plate sleeve layer 150B.

Pin ends 136 of pins 134 can thus be arranged very close together, whereby testing points on an object 152 for testing, such as printed circuit board 152, which are placed very close together can also be tested separately and simultaneously.

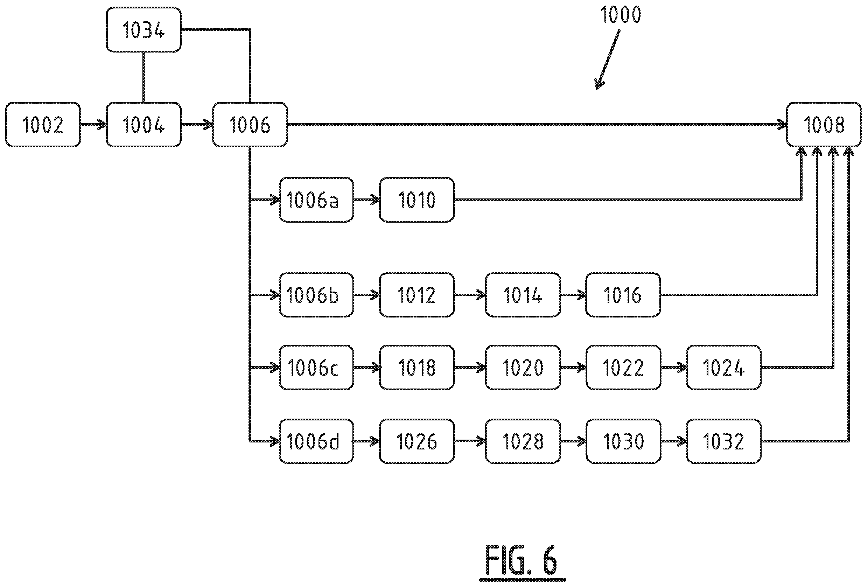

In an example of a method 1000 for replacing one or more components of a testing device for testing printed circuit boards the method comprises a number of steps (see figure 6). A first step 1002 is to provide a testing device according to the invention, followed by the step of removing 1004 the pin assembly from one or more assemblies. A further step is replacing 1006 one or more components of the assembly and placing 1008 of the pin assembly.

The step of replacing 1006 one or more components can be performed in diverse ways.

A first option is to replace 1006a the pin assembly. Such a step comprises only of exchanging 1010 the pin assembly with another, preferably new, pin assembly.

A second option, which can be performed separately or in combination with the first option, is replacing 1006b the sleeve of the sleeve assembly by uncoupling 1012 the distal and proximal outer end of the sleeve from respectively the contact plate and the control plate sleeve and then removing 1014 the sleeve for replacing. This option likewise comprises the step of placing 1016 the new sleeve and connecting the distal and proximal outer end of the sleeve to respectively the contact plate and the control plate sleeve.

A third option, which can be performed separately or in combination with the first and/or the second option, is replacing 1006c the contact plate sleeve of the sleeve assembly by uncoupling 1018 the distal outer end of the sleeve from the contact plate sleeve and removing 1020 the contact plate sleeve. This option further comprises of placing 1022 a new contact plate sleeve and connecting 1024 the distal outer end of the sleeve to the contact plate sleeve.

A fourth option, which can be performed separately or in combination with the first, the second and/or the third option, is replacing 1006d the sleeve of the control plate sleeve of the sleeve assembly by performing a number of steps. This comprises inter alia of uncoupling 1026 the proximal outer end of the sleeve from the control plate sleeve and removing 1028 the control plate sleeve. This option further comprises of placing 1030 a new control plate sleeve and connecting 1032 the proximal outer end of the sleeve to the control plate sleeve.

In this example of the method the proximal outer end and the distal outer end of the sleeve are connected releasably to respectively the control plate sleeve and the contact plate sleeve.

The step of removing 1004 can in this example comprise the step of removing 1034 the pin assembly of said assemblies from the control plate sleeve via a rear side.

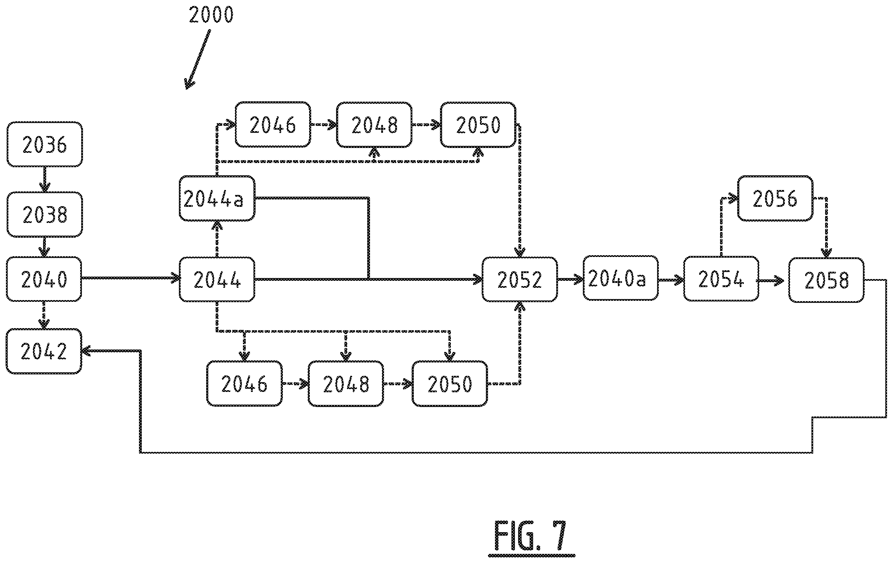

In an example of the method 2000 for testing a printed circuit board (see figure 7) the method comprises the step 2036 of providing a testing device according to the invention and providing 2038 at least one object for testing. Method 2000 further comprises of testing 2040 the object for testing and, optionally, of repeating 2042 the steps of providing an object for testing and testing the object for testing.

The step of testing 2040 the object for testing further comprises of positioning 2044 the object for testing, such as a printed circuit board, in a test position relative to the testing device and preferably relative to the contact plate thereof. The positioning 2044 preferably comprises the step of positioning 2044a such that the contacting pattern of test pins corresponds with the electrical connections for testing on the object for testing. The step of positioning 2044, 2044a optionally comprises of placing 2046 the object for testing in a test position and/or of placing 2048 the object for testing and the contact plate at a predetermined mutual distance. Method 2000, and specifically the step of testing 2040, further optionally comprises of fixing 2050 the object for testing relative to the contact plate.

The step of testing 2040 can further comprise of pushing 2052 the pins to a test position, in which the pins make electrical contact with the electrical connections, by means of drive means, wherein the pins move at least partially through the sleeve assembly and the contact plate. The pins here make electrical contact with the electrical connections. This is followed by the step of testing 2040a the object for testing and retracting 2054 the pins from the test position to a rest position, in which a distal outer end of the pins lies clear of the object for testing.

The step of testing 2040 can further optionally comprise the step of releasing 2056 the fixation of the object for testing relative to the contact plate. The step of testing 2040 can further comprise of removing 2058 the tested object.

The present invention is by no means limited to the above described preferred embodiments thereof. The rights sought are defined by the following claims, within the scope of which many modifications can be envisaged.

## Claims

1. Assembly (2) for a testing device for printed circuit boards, the assembly comprising:
- a sleeve assembly (4) configured to at least partially surround a pin (34), wherein the sleeve assembly and the pin are movable relative to each other, wherein the sleeve assembly is provided with:
~ a control plate sleeve (6) which is operatively connectable to a control plate (254);
~ a sleeve (10) provided with:
- a proximal outer end connected operatively to the control plate sleeve; and
- a distal outer end connectable to a contact plate (150) of a testing device for printed circuit boards;
- a pin assembly (38) comprising:
~ a pin base (40) which is releasably placeable in the control plate sleeve; and
~ the pin which is connected with a proximal outer end to the pin base; **characterized in that** the sleeve assembly is further provided with a contact plate sleeve (116) which is connected operatively to the distal outer end of the sleeve, wherein the contact plate sleeve is connectable to the contact plate; and **in that** the control plate sleeve is releasably connectable to the control plate.

2. Assembly according to claim 1, wherein a first outer end of the control plate sleeve is releasably operatively connected to the sleeve, and wherein the first outer end is preferably shaped as one of a male or a female end, and wherein the proximal outer end of the sleeve is shaped as the other of a male or a female end, such that the first outer end and the proximal outer end are couplable, preferably slidably couplable.

3. Assembly according to claim 2, further comprising a coupling piece, preferably provided with a female coupling piece end and a male coupling piece end lying opposite the female coupling piece end, wherein the first outer end of the control plate sleeve is couplable to one of the male or female coupling piece end and the proximal outer end of the sleeve is couplable to the other of the male or female coupling piece end.

4. Assembly according to any one of claims 1-3, wherein the contact plate sleeve is releasably connected with a first outer end to the distal outer end of the sleeve, and wherein the first outer end is preferably shaped as one of a male or a female end, and wherein the distal outer end of the sleeve is shaped as the other of a male or a female end, such that the first outer end and the distal outer end are couplable, preferably slidably couplable.

5. Assembly according to claim 4, further comprising a coupling piece, preferably provided with a female coupling piece end and a male coupling piece end, wherein the first outer end of the contact plate sleeve is couplable to one of the male or female coupling piece end and the distal outer end of the sleeve is couplable to the other of the male or female coupling piece end.

6. Assembly according to any one of the claims 1-5, wherein the contact plate sleeve is releasably, preferably slidably, connectable to the contact plate.

7. Assembly according to any one of the foregoing claims, wherein the control plate sleeve is slidably, connectable to the control plate.

8. Assembly according to any one of the foregoing claims, wherein the proximal pin end is connected moveably to the pin base, and/or wherein the pin assembly further comprises retracting means which connect the pin base and the pin to each other, wherein the pin base and the pin are movable relative to each other and wherein the retracting means are configured to push the pin to a retracted position relative to the contact plate, and wherein the retracting means preferably comprise a spring.

9. Testing device for printed circuit boards comprising at least one assembly according to any one of the foregoing claims.

10. Testing device according to claim 9, further comprising:
- at least one contact plate;
- at least one control plate;
- drive means which are connected operatively to or form part of the at least one control plate and which are configured to move the pins through the contact plate,
wherein the distal outer end of the sleeve of each of the at least one assembly is operatively connected to the contact plate, wherein each control plate sleeve of each of the at least one assembly is operatively connected to the control plate and wherein the control plate sleeve is releasably connectable to the control plate.

11. Testing device according to claim 10, wherein each control plate sleeve is arranged slidably in a control plate opening of the control plate.

12. Testing device according to any one of the claims 9-11, wherein each assembly is provided with a contact plate sleeve, wherein the contact plate is provided with contact plate openings and wherein each contact plate sleeve extends at least partially in the contact plate opening.

13. Testing device according to any one of the claims 9-12, wherein the pins are electrically connected to testing means.

14. Method for replacing one or more components of a testing device for testing printed circuit boards, the method comprising of:
- providing a testing device according to any one of the claims 9-13;
- removing the pin assembly from one or more assemblies;
- replacing one or more components of the assembly; and
- placing the pin assembly.

15. Method for testing a printed circuit board, comprising of:
- providing a testing device according to any one of the claims 9-13;
- providing at least one object for testing;
- testing the object for testing;
- optionally repeating the steps of providing an object for testing and testing the object for testing.

## Patentansprüche

1. Anordnung (2) für eine Prüfvorrichtung für Leiterplatten, die Anordnung umfassend:
- eine Hülsenanordnung (4), die konfiguriert ist, um einen Stift (34) mindestens teilweise zu umgeben, wobei die Hülsenanordnung und der Stift relativ zueinander bewegbar sind, wobei die Hülsenanordnung versehen ist mit:
~ einer Steuerplattenhülse (6), die mit einer Steuerplatte (254) wirkverbunden werden kann;
~ einer Hülse (10), die versehen ist mit:
- einem proximalen äußeren Ende, das mit der Steuerplattenhülse wirkverbunden ist; und
- einem distalen äußeren Ende, das mit einer Kontaktplatte (150) einer Prüfvorrichtung für Leiterplatten verbunden werden kann;
- eine Stiftanordnung (38), umfassend:
~ eine Stiftbasis (40), die in der Steuerplattenhülse lösbar platzierbar ist; und
~ den Stift, der mit einem proximalen äußeren Ende mit der Stiftbasis verbunden ist;
**dadurch gekennzeichnet, dass** die Hülsenanordnung ferner mit einer Kontaktplattenhülse (116) versehen ist, die mit dem distalen äußeren Ende der Hülse wirkverbunden ist, wobei die Kontaktplattenhülse mit der Kontaktplatte verbunden werden kann; und **dadurch, dass** die Steuerplattenhülse mit der Steuerplatte lösbar verbunden werden kann.

2. Anordnung nach Anspruch 1, wobei ein erstes Ende der Steuerplattenhülse mit der Hülse lösbar wirkverbunden ist und wobei das erste äußere Ende vorzugsweise als eines von einem männlichen oder einem weiblichen Ende geformt ist und wobei das proximale äußere Ende der Hülse derart als das andere von einem männlichen oder einem weiblichen Ende geformt ist, dass das erste äußere Ende und das proximale äußere Ende koppelbar, vorzugsweise verschiebbar koppelbar, sind.

3. Anordnung nach Anspruch 2, ferner umfassend ein Kopplungsstück, das vorzugsweise mit einem weiblichen Kopplungsstückende und einem männlichen Kupplungsstückende, das dem weiblichen Kopplungsstückende gegenüberliegt, versehen ist, wobei das erste äußere Ende der Steuerplattenhülse mit einem des männlichen oder des weiblichen Kopplungsstückendes koppelbar ist und das proximale äußere Ende der Hülse mit dem anderen des männlichen oder des weiblichen Kopplungsstückendes koppelbar ist.

4. Anordnung nach einem der Ansprüche 1 bis 3, wobei die Kontaktplattenhülse mit einem ersten äußeren Ende mit dem distalen äußeren Ende der Hülse lösbar verbunden ist und wobei das erste äußere Ende vorzugsweise als eines von einem männlichen oder einem weiblichen Ende geformt ist und wobei das distale äußere Ende der Hülse derart als das andere von einem männlichen oder einem weiblichen Ende geformt ist, dass das erste äußere Ende und das distale äußere Ende koppelbar, vorzugsweise verschiebbar koppelbar, sind.

5. Anordnung nach Anspruch 4, ferner umfassend ein Kopplungsstück, das vorzugsweise mit einem weiblichen Kopplungsstückende und einem männlichen Kopplungsstückende versehen ist, wobei das erste äußere Ende der Kontaktplattenhülse mit einem des männlichen oder des weiblichen Kopplungsstückendes koppelbar ist und das distale äußere Ende der Hülse mit dem anderen des männlichen oder des weiblichen Kopplungsstückendes koppelbar ist.

6. Anordnung nach einem der Ansprüche 1 bis 5, wobei die Kontaktplattenhülse lösbar, vorzugsweise verschiebbar, mit der Kontaktplatte verbunden werden kann.

7. Anordnung nach einem der vorstehenden Ansprüche, wobei die Steuerplattenhülse mit der Steuerplatte verschiebbar verbunden werden kann.

8. Anordnung nach einem der vorstehenden Ansprüche, wobei das proximale Stiftende mit der Stiftbasis bewegbar verbunden ist und/oder wobei die Stiftanordnung ferner Rückzugsmittel umfasst, die die Stiftbasis und den Stift miteinander verbinden, wobei die Stiftbasis und der Stift relativ zueinander bewegbar sind und wobei die Rückzugsmittel konfiguriert sind, um den Stift in eine zurückgezogene Position relativ zu der Kontaktplatte zu drücken und wobei die Rückzugsmittel vorzugsweise eine Feder umfassen.

9. Prüfvorrichtung für Leiterplatten, umfassend mindestens eine Anordnung nach einem der vorstehenden Ansprüche.

10. Prüfvorrichtung nach Anspruch 9, ferner umfassend:
- mindestens eine Kontaktplatte;
- mindestens eine Steuerplatte;
- Antriebsmittel, die mit der mindestens einen Steuerplatte wirkverbunden sind oder einen Teil davon ausbilden und die konfiguriert sind, um die Stifte durch die Kontaktplatte zu bewegen,
wobei das distale äußere Ende der Hülse jeder der mindestens einen Anordnung mit der Kontaktplatte wirkverbunden ist, wobei jede Steuerplattenhülse jeder der mindestens einen Anordnung mit der Steuerplatte wirkverbunden ist und wobei die Steuerplattenhülse mit der Steuerplatte lösbar verbunden werden kann.

11. Prüfvorrichtung nach Anspruch 10, wobei jede Steuerplattenhülse in einer Steuerplattenöffnung der Steuerplatte verschiebbar eingerichtet ist.

12. Prüfvorrichtung nach einem der Ansprüche 9 bis 11, wobei jede Anordnung mit einer Kontaktplattenhülse versehen ist, wobei die Kontaktplatte mit Kontaktplattenöffnungen versehen ist und wobei sich jede Kontaktplattenhülse mindestens teilweise in der Kontaktplattenöffnung erstreckt.

13. Prüfvorrichtung nach einem der Ansprüche 9 bis 12, wobei die Stifte mit Prüfmitteln elektrisch verbunden sind.

14. Verfahren zum Ersetzen einer oder mehrerer Komponenten einer Prüfvorrichtung zum Prüfen von Leiterplatten, das Verfahren umfassend:
- Bereitstellen einer Prüfvorrichtung nach einem der Ansprüche 9 bis 13;
- Entfernen der Stiftanordnung von einer oder mehreren Anordnungen;
- Ersetzen einer oder mehrerer Komponenten der Anordnung; und
- Platzieren der Stiftanordnung.

15. Verfahren zum Prüfen einer Leiterplatte, umfassend:
- Bereitstellen einer Prüfvorrichtung nach einem der Ansprüche 9 bis 13;
- Bereitstellen mindestens eines Objekts zum Prüfen;
- Prüfen des Objekts zum Prüfen;
- optional Wiederholen der Schritte des Bereitstellens eines Objekts zum Prüfen und Prüfen des Objekts zum Prüfen.

## Revendications

1. Ensemble (2) pour un dispositif de test pour cartes de circuits imprimés, l'ensemble comprenant :
- un ensemble manchon (4) conçu pour entourer au moins partiellement une broche (34), dans lequel l'ensemble manchon et la broche sont mobiles l'un par rapport à l'autre, dans lequel l'ensemble manchon est pourvu :
~ d'un manchon de plaque de commande (6) qui peut être relié de manière fonctionnelle à une plaque de commande (254) ;
~ d'un manchon (10) muni :
- d'une extrémité externe proximale reliée fonctionnellement au manchon de plaque de commande ; et
- d'une extrémité externe distale pouvant être connectée à une plaque de contact (150) d'un dispositif de test pour cartes de circuits imprimés ;
- un ensemble de broche (38) comprenant :
~ une base de broche (40) qui peut être placée de manière amovible dans le manchon de la plaque de commande ; et
~ la broche qui est reliée par une extrémité externe proximale à la base de la broche ;
**caractérisé en ce que** l'ensemble de manchon est en outre pourvu d'un manchon de plaque de contact (116) qui est relié de manière fonctionnelle à l'extrémité extérieure distale du manchon, dans lequel le manchon de plaque de contact peut être connecté à la plaque de contact ; et **en ce que** le manchon de plaque de commande est raccordable de manière amovible à la plaque de commande.

2. Ensemble selon la revendication 1, dans lequel une première extrémité extérieure du manchon de plaque de commande est reliée de manière fonctionnelle et amovible au manchon, et dans lequel la première extrémité extérieure est de préférence en forme de l'une d'une extrémité mâle ou femelle, et dans lequel l'extrémité extérieure proximale du manchon est en forme de l'autre d'une extrémité mâle ou femelle, de telle sorte que la première extrémité extérieure et l'extrémité extérieure proximale sont accouplables, de préférence accouplables de manière coulissante.

3. Ensemble selon la revendication 2, comprenant en outre une pièce d'accouplement, de préférence pourvue d'une extrémité de pièce d'accouplement femelle et d'une extrémité de pièce d'accouplement mâle située à l'opposé de l'extrémité de pièce d'accouplement femelle, dans lequel la première extrémité externe du manchon de plaque de commande est accouplable à l'une de l'extrémité de pièce d'accouplement mâle ou d'accouplement femelle et l'extrémité externe proximale du manchon est accouplable à l'autre de l'extrémité de pièce d'accouplement mâle ou d'accouplement femelle.

4. Ensemble selon l'une quelconque des revendications 1 à 3, dans lequel le manchon de plaque de contact est raccordé de manière amovible par une première extrémité externe à l'extrémité externe distale du manchon, et dans lequel la première extrémité externe est de préférence en forme de l'une parmi une extrémité mâle ou une extrémité femelle, et dans lequel l'extrémité externe distale du manchon est en forme de l'autre parmi une extrémité mâle ou une extrémité femelle, de telle sorte que la première extrémité externe et l'extrémité externe distale peuvent être accouplées, de préférence accouplées de manière coulissante.

5. Ensemble selon la revendication 4, comprenant en outre une pièce d'accouplement, de préférence pourvue d'une extrémité de pièce d'accouplement femelle et d'une extrémité de pièce d'accouplement mâle, dans lequel la première extrémité externe du manchon de plaque de contact peut être accouplée à l'une de l'extrémité de pièce d'accouplement mâle ou d'accouplement femelle et l'extrémité externe distale du manchon peut être accouplée à l'autre de l'extrémité de pièce d'accouplement mâle ou d'accouplement femelle.

6. Ensemble selon l'une quelconque des revendications 1 à 5, dans lequel le manchon de plaque de contact peut être raccordé de manière amovible, de préférence de manière coulissante, à la plaque de contact.

7. Ensemble selon l'une quelconque des revendications précédentes, dans lequel le manchon de plaque de commande est raccordable de manière coulissante à la plaque de commande.

8. Ensemble selon l'une quelconque des revendications précédentes, dans lequel l'extrémité proximale de broche est reliée de manière mobile à la base de broche, et/ou dans lequel l'ensemble de broche comprend en outre des moyens de rétraction qui relient la base de broche et la broche l'une à l'autre, dans lequel la base de broche et la broche sont mobiles l'une par rapport à l'autre et dans lequel les moyens de rétraction sont conçus pour pousser la broche vers une position rétractée par rapport à la plaque de contact, et dans lequel les moyens de rétraction comprennent de préférence un ressort.

9. Dispositif de test pour cartes de circuits imprimés comprenant au moins un ensemble selon l'une quelconque des revendications précédentes.

10. Dispositif selon la revendication 9, comprenant en outre :
- au moins une plaque de contact ;
- au moins une plaque de commande ;
- des moyens d'entraînement qui sont reliés de manière fonctionnelle à l'au moins une plaque de commande ou qui en font partie et qui sont conçus pour déplacer les broches à travers la plaque de contact,
dans lequel l'extrémité extérieure distale du manchon de chacun de l'au moins un ensemble est reliée de manière fonctionnelle à la plaque de contact, dans lequel chaque manchon de plaque de commande de chacun de l'au moins un ensemble est relié de manière fonctionnelle à la plaque de commande et dans lequel le manchon de plaque de commande peut être relié de manière amovible à la plaque de commande.

11. Dispositif de test selon la revendication 10, dans lequel chaque manchon de plaque de commande est agencé de manière coulissante dans une ouverture de plaque de commande de la plaque de commande.

12. Dispositif de test selon l'une quelconque des revendications 9 à 11, dans lequel chaque ensemble est pourvu d'un manchon de plaque de contact, dans lequel la plaque de contact est pourvue d'ouvertures de plaque de contact et dans lequel chaque manchon de plaque de contact s'étend au moins partiellement dans l'ouverture de plaque de contact.

13. Dispositif de test selon l'une quelconque des revendications 9 à 12, dans lequel les broches sont connectées électriquement à des moyens de test.

14. Procédé de remplacement d'un ou plusieurs composants d'un dispositif de test pour tester des cartes de circuit imprimé, le procédé comprenant :
- la fourniture d'un dispositif selon l'une quelconque des revendications 9 à 13 ;
- le retrait de l'ensemble de broche d'un ou plusieurs ensembles ;
- le remplacement d'un ou plusieurs composants de l'ensemble ; et
- la mise en place de l'ensemble de broche.

15. Procédé de test d'une carte de circuit imprimé, comprenant :
- la fourniture d'un dispositif selon l'une quelconque des revendications 9 à 13 ;
- la fourniture d'au moins un objet à tester ;
- le test de l'objet à tester ;
- la répétition facultative des étapes consistant à fournir un objet à tester et à tester l'objet à tester.
